# EUROPEAN PATENT APPLICATION

(11) **EP 1 972 908 A1**
(43) Date of publication of application: **24.09.2008**
(21) Application number: 06822974.9
(22) Date of filing: 30.10.2006
(51) Int. Cl.: G01H 17/00, G01N 29/14

(54) **AE SENSOR AND METHOD FOR CHECKING OPERATING STATE OF AE SENSOR**

(30) Priority: 12.01.2006 JP 2006004730
(71) Applicant: TOKYO SEIMITSU CO., LTD., Mitaka-shi Tokyo 181-8515 (JP)
(72) Inventor: MEKI, Kazuo, Ibaraki 300-0006 (JP)
(74) Representative: Cohausz & Florack
(86) International application number: PCT/JP2006/322056
(87) International publication number: WO 2007/080692

(57) **Abstract**

The object is to make iL possible to check the operating state such as degradation in sensitivity of an AE sensor when it is used actually. There are provided an AE conversion element 41, a pulse signal transmitter 42 for applying a pulse signal to the AE conversion element through the output passage of an AE signal from AE conversion element 41, a receiver/processor 43 for converting the AE signal into a digital signal and calculating the frequency characteristics by processing the digital signal, a reference frequency characteristic storage section 44 for storing the frequency characteristics of Lhe AE signal of the AE conversion element in the reference state as reference frequency characteristics, and a comparator 45 for comparing the frequency of the AE signal calculated in response to an operation check request signal with Lhe reference frequency characteristics.

## Description

### FIELD OF THE INVENTION

The present invention relates to an acoustic emission (AE) sensor for detecting an AE signal of a high frequency that propagates within a solid medium and a method for checking whether an AE sensor operates normally, and more specifically, to an AE sensor used by being attached to part of a working system for working a work by causing a tool, such as a grindstone, to come into contact with the work and a method for checking the operating state thereof.

### BACKGROUND OF THE INVENTION

In a working device for working a work by causing a tool to come into contact with the work, for example, in a grinder for grinding a work by causing a rotating grindstone to come into contact with a rotating work, an AE sensor is used to detect a contact (air cut) between a tool (grindstone) and a work, to detect the completion of dressing of a tool (grindstone) by a dressing tool. (dresser), to position a tool (grindstone) by detecting that the tool has come into contact with a predetermined reference pin, to detect a collision of a tool (grindstone) with other portions of the working device, etc. AE, sensors detect an AE signal that propagates within a solid and includes various types depending on target frequencies, etc. An AE sensor used in a working device, such as a grinder, targets an ultrasonic region of tens of kilohertz to hundreds of megahertz and comprises a piezoelectric element etc.

The following explanation is given using an AE sensor used in a grinder as an example; however, the present invention is not limited to this, and can be applied to any type of AE sensor.

An AE sensor is known widely as described in NDTS No. 2106-79, 2106-1, etc., and a grinder that uses an AE sensor is also know widely as described in patent document 1 etc., and therefore, a detailed explanation of the AE sensor is omitted. Only a part that directly relates to the present invention will be explained.

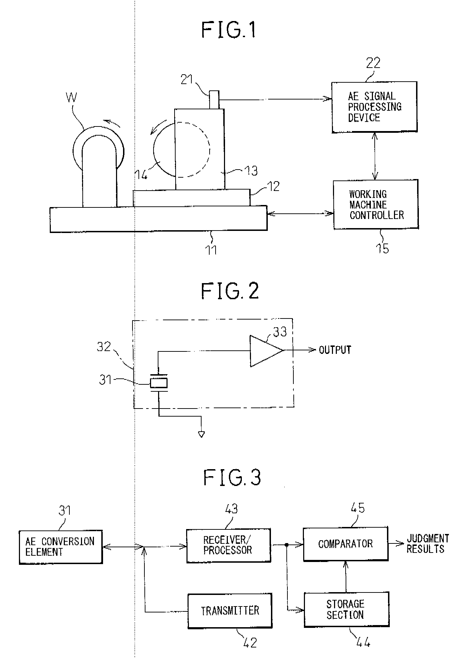

Fig. 1 is a diagram showing an example of the use of an AE sensor, and also a diagram showing a configuration in which an AE sensor is provided in a working system including a grinder. In the following explanation, a case in which an AE sensor is applied to such a configuration as shown in Fig. 1 is taken as an example. In Fig. 1, on a base 11, a mechanism for retaining and rotating a work W and a moving base 12 are provided. Moving base 12 is provided with a grindstone rotating mechanism 13 for rotating a grindstone 14. The grinder is controlled by a working machine controller 15. Grindstone 14 is subjected to processing known as dressing processing for bringing the surface of grindstone 14 into a state suitable for grinding when it is replaced with a new one or it is used for a certain period of time. In this processing, the surface of rotating grindstone 14 is processed by causing a dresser to come into contact with rotating grindstone 14. The parts described above are the same as those of a working system including a normal grinder used in manufacturing.

To the housing of grind rotating mechanism 13, an acoustic emission (AE) sensor 21 is attached and an AE wave generated in grindstone 14 is transferred to AE sensor 21 through the housing of grindstone rotating mechanism 13, and then AE sensor 21 generates an AE signal. An AE signal processing device 22 processes the AE signal and detects that grindstone 14 has come into contact with work W and notifies working machine controller 15.

Fig. 2 is a diagram showing a circuit configuration of the AE sensor. In Fig. 2, reference number 31 denotes an AE conversion element, 32 denotes a case that accommodates AE conversion element 31, and 33 denotes a preamplifier. AE conversion element 31 is made of a piezoelectric material, such as lead zirconium titanium (PZT) based piezoelectric ceramic, lithium niobate, and crystal. AE conversion element 31 is connected to preamplifier 33 and an output in accordance with the change in impedance of AE conversion element 31 due to the AE wave from preamplifier 33 is obtained. In the example in Fig. 1, case 32 is attached to the housing of grindstone rotating mechanism 13 as AE sensor 21 and AE conversion element 31 and preamplifier 33 are provided in case 32.

A conventional method for measuring the sensitivity of and troubleshooting an AE sensor, which is carried out conventionally, is carried out by receiving a signal from a reference AE wave generation source having a predetermined relationship with a sensor Lo be diagnosed and analyzing the received signal. The reference AE wave generation source either generates the AE wave by, for example applying a predetermined signal to the AE sensor or generates the AE wave by applying Lhe lead of a mechanical pencil with pressure. In order to carry out such measurements, it is necessary for the sensor to be diagnosed and the reference AE wave generation source to be in a predetermined relationship, for example, they are arranged in a predetermined positional relationship with respect to a predetermined measuring medium. The measurement methods further includes the NTST method, the reciprocity method, etc.

The AE sensor is examined before its shipment by the above-described sensitivity measuring and troubleshooting method and those which satisfy a predetermined criterion are shipped
Patent document 1: Japanese Unexamined Patent Publication (Kokai) NO. H6-114692

### DISCLOSURE OF THE INVENTION

AE conversion element 31 has a configuration in which electrodes are provided on both sides of a piezoelectric element, and if necessary, a reception plate and an insulation plate are further provided, and wires are provided between the electrodes and output terminals. During its use, a problem occurs in which no output is generated because of various kinds of problems, such as, breakage of wire, exfoliation of an electrode, and degradation of a piezoelectric element, or degradation in sensitivity may occur. When such problems occur, it is no longer possible to correctly detect a contact of a grindstone with a work.

Therefore, when the AE sensor is used to detect a contact of grindstone with a work in the configuration as shown in Fig. 1, it is checked that the AE sensor operates by detecting the output thereof in a state where the grindstone is not in contact with the work. However, what is detected in such a state is noise resulting from the vibrations at rotating portions, such as a motor, and bearing, the flows of grinding oil, lubrication oil, and air, the drive of a pump, etc., and the noise is not constant. Therefore, even if the output of the AE sensor is measured in such a state, it is not possible to measure with precision degradation in sensitivity of the AE sensor, but only to determine whether the AE sensor is operating.

As described above, the conventional method for measuring sensitivity of an AE sensor requires that the AE sensor and the reference AE wave generation source be arranged in a predetermined positional relationship with respect to a predetermined measuring medium, and therefore, this method cannot be used in the configuration as shown in Fig. 1.

An object of the present invention is to make it possible to check the operating state such as degradation in sensitivity of an AE when it is used actually.

In order to realize the above object, the AE sensor and the method for checking the operating state of an AE sensor of the present invention store the characteristics of the self-resonance at the time of normal operation such as at the time of shipment as reference characteristics by utilizing the piezoelectric effect and self-resonance of the AE conversion element and judge the operating state based on the amount of deviation from the reference characteristics.

Fig. 3 is a block diagram showing the basic configuration of the AE sensor of the present invention. As shown the AE sensor of the present invention is characterized by comprising AE conversion element 31, a pulse signal transmitter 42 for applying a pulse signal to the AE conversion element through the output passage of an AE signal from AE conversion element 31, a receiver/processor 43 for receiving and converting the AE signal into a digital signal and calculating the frequency characteristics by processing the digital AE signal, a reference frequency characteristic storage section 44 for storing the frequency characteristics of the AE signal when the pulse signal is applied to the AE conversion element in the reference state from the pulse signal transmitter as the reference frequency characteristics, and a comparator 45 for comparing the frequency characteristics of the AE signal when the pulse signal is applied to the AE conversion element from the pulse signal transmitter in response to an operation check request signal with the reference frequency characteristics.

Tn addition, the method for checking the operating state of an AE sensor of the present invention is characterized by applying a pulse signal to the AE conversion element in the reference state through the output passage of an AE signal from an AE conversion element, calculating and storing the frequency characteristics of the AE signal output from the AE conversion element in accordance with the application of the pulse signal as the reference frequency characteristics, applying a pulse signal to the AE conversion element in response to an operation check request signal, calculating the frequency characteristics of the AE signal output from the AE conversion element in accordance with the application of the pulse signal as operation check frequency characteristics, comparing the operation check frequency characteristics with the reference frequency characteristics and judging that the operation is normal when their difference is smaller than a predetermined amount and abnormal when it is larger than the predetermined amount, and outputting judgment results.

According Lo the present invention, the pulse signal transmitter generates a predetermined pulse signal for measurement and the pulse signal for measurement is applied to the AE conversion element through the output passage of the AE signal from the AE conversion clement. In accordance with the pulse signal, the AE conversion element self-resonates and outputs an AE signal. The pulse signal for measurement is fixed and the passage through which the pulse signal for measurement is applied to the AE conversion element from the pulse signal transmitter and the passage through which the AE signal is output from the AE conversion element are also fixed, and therefore, the measuring system is a closed passage and it is possible to measure with precision degradation in sensitivity of an AE sensor.

At the time of shipment or maintenance, the operation check of an AE sensor is carried out, and therefore, it is possible for the AE sensor to operate normally. The AE signal to be output from the AE sensor in accordance with the pulse signal for measurement at this time is the AE signal when the sensor is normal and it is stored as the reference signal. In order to store and compare the AE signal, it is necessary to make use of the frequency characteristics of the AE signal and the reference AE signal and the AE signal to be compared are analysed on their frequency and their frequency characteristics are calculated.

However, the AE sensor and the method for checking an AE sensor of the present invention make use of the measurement in the closed system of the AE sensor, and therefore, it is not possible to identify, for example, factors that occur outside the AE sensor, such as looseness in attachment of the AE sensor.

According to the present invention, it is possible to check the operating state such as degradation in sensitivity of an AE sensor when it is actually used, and it is also possible to improve the reliability of the use of the AE sensor.

### BRIEF DESCRIPTION OF THE DRAWINGS

Fig. 1 is a diagram showing a configuration example of a machining system in which an AE sensor is used.
Fig. 2 is a diagram showing a circuit configuration of an AE sensor.
Fig. 3 is a diagram showing a basic configuration of an AE sensor of the present invention.
Fig. 4 is a diagram showing a configuration of an AE sensor in an embodiment of the present invention.
Fig. 5A is a diagram showing an example of a pulse signal for to be applied to an AE conversion element.
Fig. 5B is a diagram showing an example, of an AE signal by the pulse signal for measurement in Fig. 5A.
Fig. 6 is a flowchart showing a method for using an AE sensor in an embodiment.

### DESCRIPTION OF PREFERRED EMBODIMENTS

An AE sensor in an embodiment of the present invention is explained below. The AE sensor in the embodiment is used, for example, in a grinder shown in Fig. 1. In the following explanation, a case is explained as an example, where the AE sensor in the embodiment, is used in the grinder in Fig. 1.

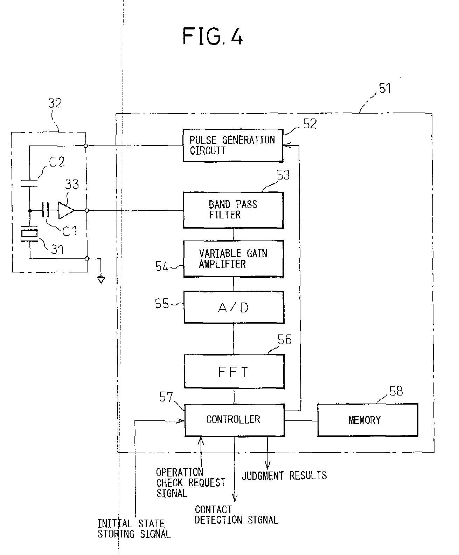

Fig. 4 is a diagram showing a configuration of the AE sensor in the embodiment. As shown schematically, the AE sensor in the embodiment has AE conversion element 31 and a signal processing section 51 corresponding to AE signal processing device 22 in Fig. 1. AE conversion element 31 is accommodated in case 32 along with capacitors C1, C2 and preamplifier 33, and the case 32 is attached to the housing portion etc. of the grindstone rotating mechanism in Fig. 1. Case 32 and signal processing section 51 are connected via a cable etc.

Signal processing section 51 has a pulse generation circuit 52 that is connected via AE conversion element 31 and capacitor C2 and which outputs a pulse for measurement a band pass filter 53 that is connected via AE conversion element 31, capacitor C1, and preamplifier 33 and which causes signals in a frequency range, which targets AE waves, for example, in a range of 20 kHz to 500 kHz among analog AE signals output from AE sensor 31 to pass through and cuts off other signals of other frequencies, a variable gain amplifier 54 for amplifying the signals having passed through band pass filter 53 to a predetermined power, an A/D converter 55 for converting the analog signal output from variable gain amplifier 54 into a digital. AE signal, a fast Fourier transformer (FFT) 56 for analyzing the frequency of the digital signal output from A/D converter 55, a controller 57 for reading the frequency characteristics of the AE signal output from FFT 56 as well as controlling FFT 56, and a memory 58. FFT 56 comprises a digital signal processor (DSP). The analytic processing of frequency using a DSP is widely known, and Wherefore, its explanation is omitted here.

Controller 57 is realized using a microcomputer etc. Memory 58 comprises a nonvolatile memory for storing the reference frequency characteristics as well storing programs of the microcomputer part of which constitutes controller 57. Controller 57 is configured so as to receive an initial state storing signal from outside at the time of shipment and at the same time to output judgment results and a contact detection signal to working machine controller 15 as well as receiving an operation check request signal from working machine controller 15 in Fig. 1. In addition, controller 57 controls pulse generation circuit 52 to output a pulse for measurement or not.

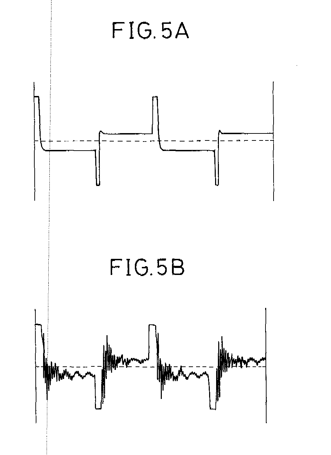

Fig. 5A shows an example of a pulse signal for measurement to be applied to AE conversion element 31 from pulse generation circuit 52 via capacitor C2. As shown schematically, a fine pulse is output in the positive (plus) direction and then a fine pulse is output in the negative (minus) direction, and this action is repeated on a predetermined cycle.

When the pulse signal with such a waveform as shown in Fig. 5A is applied, AE converter 31 resonates and outputs such an AE signal as shown in Fig. 5B, the output of which oscillates after the application of the pulse, via capacitor C1 and preamplifier 33 and the signal enters band pass filter 53. If AE conversion element 31 is not connected or the wire is broken, the pulse signal with the waveform as shown in Fig. 5A enters band pass filter 53 directly as a result. If the sensitivity of AE conversion element 31 is degraded, the portion the output of which oscillates even after the application of the pulse will vary. If the analysis of the frequency of the signal at the portion the output of which oscillates even after the application of the pulse is carried out in FFT 56, a frequency component is calculated, which varies so that it has local maxima at the resonance frequency of AE conversion element 31 and the portion of integer multiples thereof.

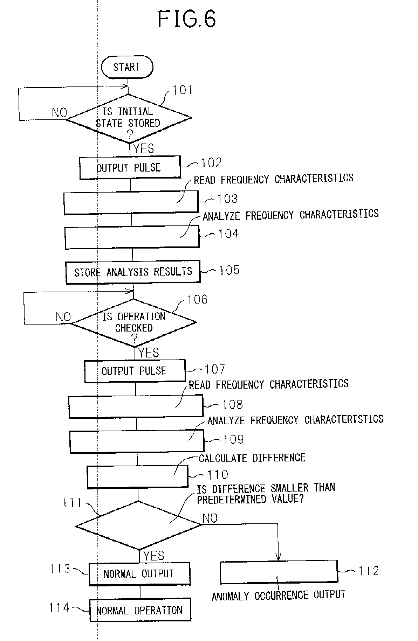

Fig. 6 is a flowchart explaining the operation to store the reference frequency characteristics and check the operating state based thereon in the AE sensor in the embodiment.

In step 101, the standby state continues until the initial state storing signal is input from outside and when the input of the initial state storing signal is detested, the procedure proceeds to the next step 102. The initial state storing signal is input from outside when it is ensured that the operation is normal such as at the time of shipment or when maintenance is carried out.

In step 102, pulse generation circuit 52 outputs the pulse for measurement. When the pulse for measurement is output, AE conversion element 31 resonates and such an AE signal as shown in Fig. 5B is input to band pass filter 53, and then FFT 56 calculates and outputs the frequency characteristics thereof.

In step 103, controller 57 reads the frequency characteristics output from FFT 56 in accordance with the pulse for measurement.

In step 104, controller 57 analyzes the read frequency characteristics and calculates the local maxima, that is, the frequency positions of the resonance frequency and the integer multiples thereof, and their power values. If necessary, the local minima are also calculated.

In step 105, controller 57 stores the results of analysis in step 104 in the nonvolatile memory of memory 58 as the reference frequency characteristics. Therefore, the stored reference frequency characteristics are unlikely to be deleted even if the power supply to the AE sensor is terminated.

The above operations are carried out at the time of shipment and are carried out at the time of maintenance, etc.

The operations in step 106 and subsequent steps are carried out when it is used actually.

In step 106, the standby state continues until the operation check request signal is input from working machine controller 15 and when the input of the operation check request signal is detected, the procedure proceeds to the next step 107. Working machine controller 15 outputs the operation check request signal before causing grindstone 14 to come into contact with work W.

In step 107 to step 109, the same operations as those in step 102 to step 104 are carried out.

In step 110, the difference between the positions of the local maxima of the frequency characteristics calculated in step 109 and the difference between their power values are calculated.

In step 111 , it is determined whether the difference calculated in step 110 is smaller than a predetermined value and if not, the procedure proceeds to step 112, and if so, the procedure proceeds to step 113. In this judgment method, the setting can be done in a variety of ways, for example, anomaly is judged to be present when one of the differences between the positions of the local maxima or their sum value exceeds a predetermined value, or anomaly is judged to present when one of the power values of the local maxima and the local minima, or the sum of their power values exceeds a predetermined value.

In step 112, it can be thought that an anomaly has occurred because the calculated frequency characteristics considerably change from the reference frequency characteristics, and therefore, the judgment result indicative of an anomaly is output to working machine controller 15. In response to this, working machine controller 15 notifies the operator of the occurrence of an anomaly.

In step 113, it can be thought that the state is normal because the calculated frequency characteristics do not change considerably from the reference frequency characteristics, and therefore, the judgment result indicative of a normal state is output to working machine controller 15. Then, the normal operation state in step 114 is entered and when a large change of the AE signal is detected, contact detection signal is output. Working machine controller 15 controls grindstone 14 to come into contact with work W and when detecting a contact detection signal, working machine controller 15 controls to change the feeding speed of grindstone 14 to a lower speed for carrying out precise machining.

The embodiments of the present invention are described as above; however, there can be various modifications. For example, a grinder is explained as an example, which causes a grindstone to come into contact with a work for machining; however, the present invention is not limited to this, and can be applied to any type of AE sensor.

In addition, the analysis, storage, and comparison of the frequency characteristics of an As signal should be determined appropriately depending on the specifications of the AE sensor to be used and the object to which the AE sensor its attached, and there can be various modifications. For example, there can be a modification, in which the differences between the frequency characteristics of the detected AE signal and the stored reference frequency characteristics are integrated over the entire target of the frequency region and whether the difference between the integrated values is smaller than or equal to a predetermined values is judged.

The present invention can be applied to any type of AE sensor and, in particular, if applied to an AE sensor that is attached to a working machine, it is possible Lo improve the reliability of the judgment by the AE sensor and prevent the occurrence of trouble.

## Claims

1. An AE sensor, comprising
an AE conversion element:
a pulse signal transmitter for applying a pulse signal to the AE conversion element through the output passage of an AE signal from the AE conversion element;
a receiver/processor for receiving and converting the AE signal into a digital signal and calculating the frequency characteristics by processing the digital AE signal;
a reference frequency characteristic storage section for storing the frequency characteristics of the AE signal when the pulse signal is applied to the AE conversion element in the reference state from the pulse signal transmitter as reference frequency characteristics; and
a comparator for comparing the frequency characteristics of the AE signal when the pulse signal is applied to the AE conversion element from the pulse signal transmitter in response to an operation check request signal with the reference frequency characteristics.

2. A method for checking the operating state of an AE sensor, the method comprising:
applying a pulse signal to an AE conversion in the reference state through the output passage of an AE signal from the AE conversion element;
calculating and storing Lhe frequency characteristic of the AE signal output from Lhe conversion element in accordance with the application of the pulse signal as reference frequency chararacteristics;
applying a pulse signal to the AE conversion element in response to an operation check request signal;
calculating the frequency characteristics of the AE signal output from the AE conversion element in accordance with the application of the pulse signal as operation check frequency characteristics; and
comparing the operation check frequency characteristics with the reference frequency characteristics and judjing that the sensor is normal when the difference is smaller than a predetermined amount or that the sensor is abnormal when the difference is greater the predetermined amount, and outputting judgment results.
